# EUROPÄISCHE PATENTANMELDUNG

(11) **EP 2 851 695 A1**
(43) Veröffentlichungstag der Anmeldung: **25.03.2015**
(21) Anmeldenummer: 13185685.8
(22) Anmeldetag: 24.09.2013
(51) Int. Cl.: G01R 31/02, G01R 31/08, G01R 31/11, G01R 31/12

(54) **Teilleiterschlussprüfung von Ständerstäben elektrischer Maschinen**

(71) Anmelder: Siemens Aktiengesellschaft, 80333 München (DE)
(72) Erfinder: Staubach, Christian, 45768 Marl (DE)

(57) **Zusammenfassung**

Die Erfindung bezieht sich auf ein Verfahren und eine Vorrichtung (10)zur Überprüfung einer Vielzahl von gegeneinander isolierten Einzelleitern in einem Ständerwicklungsstab (1) einer elektrischen Maschine. Das Verfahren umfasst ein Einkoppeln (100) eines Prüfsignals (U1), ein Ermitteln (200) eines ersten Anteils des Prüfsignals (U1) und ein Vergleichen (300) zumindest des ersten Anteils mit einem Referenzsignal (Uref), um eine Beschädigung einer Isolierung zwischen einzelnen der Vielzahl der Einzelleiter zu ermitteln. Die erfindungsgemäße Vorrichtung (10) umfasst eine Signalquelle (12) und eine Messvorrichtung (14). Das erfindungsgemäße Verfahren und die erfindungsgemäße Vorrichtung (10) eignen sich insbesondere zur Überprüfung von Ständerwicklungsstäben (1), wie sie in einem Generator und/oder einem Elektromotor verwendet werden.

## Beschreibung

Die Erfindung betrifft ein Verfahren zur Überprüfung einer Vielzahl von gegeneinander isolierten Einzelleitern in einem Ständerwicklungsstab einer elektrischen Maschine und eine entsprechende Vorrichtung. In elektrischen Maschinen, insbesondere in rotierenden elektrischen Maschinen, wie zum Beispiel Motoren oder Generatoren, werden sogenannte Ständerwicklungsstäbe verwendet, um die Stromdichte innerhalb der elektrischen Maschine zu verstetigen und induzierte Wirbelströme soweit als möglich zu reduzieren. Dazu sind die rotierenden Maschinen aus einer Vielzahl von Teilleitern bzw. Einzelleitern aufgebaut. Die Einzelleiter sind gegeneinander isoliert mittels einer entsprechenden Teilleiterisolierung, wie sie dem Fachmann bekannt ist. Weiter ist es ein gängiges Vorgehen, die Teilleiter zu verröbeln, um Verluste durch induzierte Wirbelströme zu minimieren. Bei der Herstellung von großen elektrischen Maschinen, die auch als rotierende Maschinen bezeichnet werden können, ist es erforderlich, die Einzelleiter zu verbacken, um die gewünschte Isolation der Einzelleiter, und damit deren galvanische Trennung zu erreichen. Dazu werden die Teilleiter als sogenannte Ständerwicklungsstäbe aufgebaut, die ihrerseits ein gewünschtes Maß an Verröbelung erhalten, und soweit dies erforderlich ist, gebogen werden. Die gewünschte Verröbelung verursacht ebenso wie das Verbiegen eine mechanische Beanspruchung, die dazu führen kann, dass die Einzelleiterisolation beschädigt wird, so dass es zu elektrischen Schlüssen zwischen einzelnen der Einzelleiter eines Ständerwicklungsstabs kommen kann. Diese unerwünschten elektrischen Verbindungen zwischen Einzelleitern, beeinträchtigen die galvanische Isolation der Einzelleiter und führen im Betrieb der Maschine, etwa des Dreh-(strom)motors oder des Generators dazu, dass ein Risiko eines frühzeitigen Ausfalls besteht. Dadurch wird die Lebensdauer und/oder Leistungsfähigkeit der Maschine erheblich beeinträchtigt. Es ist daher von Interesse entsprechende mögliche Verletzungen der Einzelleiterisolation bereits bei der Herstellung zu erkennen. Bisher war es üblich, die Einzelleiter eines Ständerstabs zu überprüfen, bevor der Ständerwicklungs- bzw. der Einzelständerstab, an seinen beiden Enden konsolidiert, d.h. elektrisch mit den weiteren Teilen der Maschine verbunden wurde. Dazu war es üblich, mittels eines geeigneten Messgeräts, etwa eines Multimeters, den Ständerstab bzw. Ständerwicklungsstab auf mögliche Teilleiterschlüsse, das heißt elektrische Verbindung zwischen einzelnen der Einzelleiter zu überprüfen, was auf eine Beschädigung der elektrischen Isolation zwischen einzelnen der Vielzahl von Einzelleitern innerhalb des Ständerwicklungsstabs hinweist. Mittels eines Multimeters war es bisher erforderlich, jeden Einzelleiter gegenüber den übrigen Einzelleitern auf elektrische insbesondere niederohmige Verbindung zu überprüfen.

Dieses Vorgehen im Stand der Technik war sehr zeit- und kostenintensiv, da es für einen Ständerwicklungsstab, der zum Beispiel aus 50 Einzelleitern aufgebaut ist, die entsprechend gegeneinander verröbelt sind, erforderlich ist, jeden Einzelleiter auf Isolation zu den übrigen Einzelleitern innerhalb des Ständerwicklungsstabs zu überprüfen. Das heißt, es müssen insgesamt 1225 Kombinationen von Einzelleitern überprüft werden. Es sind also zur vollständigen Überprüfung 1225 Messschritte notwendig. Darüber hinaus kann im Stand der Technik die entsprechende Messung mittels des Multimeters, wie oben beschrieben, nur stattfinden, solange die Einzelleiter, die zu dem Ständerwicklungsstab zusammengefügt werden sollen, noch nicht konsolidiert sind. Das heißt, diese Messungen müssen schon vor Aufbringen der entsprechenden Isolation bzw. vor Einbau der Röbelstäbe in das Ständerblechpaket durchgeführt werden, da zu einem späteren Zeitpunkt keine Messung mehr möglich ist. Daraus ergibt sich insbesondere, dass Vorbeschädigungen, zum Beispiel während des Transports, die erst durch zusätzliche mechanische Beanspruchung etwa Pressung nach Einbau der Stäbe bzw. Röbelstäbe in das Blechpaket zu niederohmigen Schlüssen zwischen den Einzelleitern führen, nicht erkannt werden. Das heißt, im Stand der Technik konnte es vorkommen, dass die zeitaufwändige Messung keine Verletzungen der Isolation der Einzelleiter gegeneinander angezeigt hat, obgleich diese nach abgeschlossenem Einbau vorliegt.

Diese Probleme werden durch das erfindungsgemäße Verfahren zur Überprüfung einer Vielzahl von gegeneinander isolierten Einzelleitern in einem Ständerwicklungsstab einer elektrischen Maschine behoben, denn durch das erfindungsgemäße Verfahren werden elektrische Verbindungen, insbesondere niederohmige Schlüssel zwischen einzelnen der Einzelleiter auch nach Fertigstellung des Ständerwicklungsstabs detektierbar. Eine entsprechende Vorrichtung zur Überprüfung einer Vielzahl von Einzelleitern in einem Ständerwicklungsstab einer elektrischen Maschine gemäß der vorliegenden Erfindung löst ebenso die Probleme im Stand der Technik.

Aufgabe der Erfindung ist es ein Verfahren und eine Vorrichtung zur Überprüfung einer Vielzahl von gegeneinander isolierten Einzelleitern in einem Ständerwicklungsstab einer elektrischen Maschine bereitzustellen, das auch fertig hergestellte Ständerwicklungsstäbe zuverlässig auf eine Verletzung der Isolierung zwischen einzelnen der Vielzahl der Einzelleiter überprüfen kann. Ebenso ist es ein Vorteil des vorliegenden Verfahrens und der Vorrichtung gemäß der Erfindung, dass eine einzelne Messung zum Überprüfen der Einzelleiter innerhalb des Ständerwicklungsstabs ausreichend ist. Dadurch wird die Überprüfung eines fertig hergestellten Ständerwicklungsstabs zeitsparender und kostengünstiger möglich als im Stand der Technik.

Das erfindungsgemäße Verfahren zur Überprüfung einer Vielzahl von gegeneinander isolierten Einzelleitern in einem Ständerwicklungsstab einer elektrischen Maschine umfasst einen Schritt des Einkoppelns eines Prüfsignals, einen Schritt des Ermittelns eines ersten Anteils des Prüfsignals und einen Schritt des Vergleichens. Der Schritt des Einkoppelns eines Prüfsignals umfasst ein Einkoppeln des Prüfsignals in eine Vielzahl von Einzelleitern des Ständerwicklungsstabs. Der Schritt des Vergleichens umfasst erfindungsgemäß ein Vergleichen zumindest des ersten Anteils des Prüfsignals mit einem Referenzsignal, um so eine Beschädigung einer Isolierung, das heißt einer galvanischen Trennung zwischen einzelnen der Vielzahl der Einzelleiter zu ermitteln.

Dieses Verfahren ist vorteilhaft, um eine Vielzahl von Einzelleitern innerhalb des Ständerwicklungsstabs mit nur einer Messung zu überprüfen. Dadurch wird die Qualitätssicherung des Ständerwicklungsstabs kosten- und zeitgünstiger. Unter Einkoppeln ist zu verstehen, dass ein Prüfsignal in die Vielzahl von Einzelleitern des Ständerwicklungsstabs eingebracht wird. Dem Fachmann sind entsprechende Verfahren bekannt. So kann das Einkoppeln über eine elektrische Verbindung, eine induktive Kopplung und/oder eine kapazitive Kopplung zwischen einer Signalquelle und dem Ständerwicklungsstab erfolgen, so dass der Ständerwicklungsstab und damit Einzelleiter des Ständerwicklungsstabs mit dem Prüfsignal beaufschlagt sind. Unter dem ersten Reflexionsanteil des Prüfsignals ist jener Anteil des Prüfsignals zu verstehen, der von der Vielzahl der Einzelleiter reflektiert wird, und daher am Einkoppelpunkt bzw. am Ort des Einkoppelns detektierbar ist.

Vorzugsweise umfasst der Schritt des Ermittelns ein Ermitteln eines ersten Reflektionsanteils des Prüfsignals und/oder eines ersten Transmissionsanteils. Daraus ergibt sich der Vorteil, dass für die Prüfung der Ständerwicklungsstäbe wahlweise nur eine oder zwei Verbindungen mit dem Ständerwicklungsstab erforderlich sind. Der Fachmann hat also eine Freiheit, wie die Prüfung der Ständerwicklungsstäbe zu erfolgen hat. Darüber hinaus ergeben sich aus dem Ermitteln von Reflektionsanteil und Transmissionsanteil zwei Größen, die in eine Fehlerprüfung eingehen können.

Vorzugsweise umfasst der Schritt des Einkoppelns ein Einkoppeln an einem ersten Abschnitt des Ständerwicklungsstabs oder an einem ersten Endabschnitt des Ständerwicklungsstabs. Es kann vorteilhaft sein, den Schritt des Einkoppelns an einem ersten Abschnitt des Ständerwicklungsstabs vorzunehmen, der nicht ein Endabschnitt des Ständerwicklungsstabs ist. Dies kann sich zum Beispiel aus Fertigungsgegebenheiten ergeben. Wird das Prüfsignal an einem ersten Abschnitt eingekoppelt, der nicht Endabschnitt des Ständerwicklungsstabs ist, so kann dies bedeuten, dass nicht die gesamte Länge der Einzelleiter innerhalb des Ständerwicklungsstabs überprüft werden.

Ebenso ist es denkbar, das Prüfsignal an einem ersten Endabschnitt des Ständerwicklungsstabs einzukoppeln, da dieser Endabschnitt mit weiteren Abschnitten der elektrischen Maschine im weiteren Fertigungsprozess verbunden wird, wodurch sich sicherstellen lässt, dass im Wesentlichen die gesamte Länge des im Folgenden zu konsolidierenden Ständerwicklungsstabs frei von Beschädigungen der Isolierung zwischen einzelnen der Vielzahl der Einzelleiter ist. Durch die Wahlfreiheit des Einkoppelpunkts als ersten Abschnitt und/oder ersten Endabschnitt des Ständerwicklungsstabs lässt sich das erfindungsgemäße Verfahren an jeweils vorliegende Gegebenheiten während des Fertigungsprozesses flexibel anpassen. Es ist weiter bevorzugt den Schritt des Ermittelns als ein Ermitteln des ersten Reflexionsanteils an den ersten Abschnitt oder an dem ersten Endabschnitt des Ständerwicklungsstabs auszuführen. Wenn der Ort des Einkoppelns bzw. der Abschnitt zum Einkoppeln und zum Ermitteln gleich sind, vereinfacht sich das erfindungsgemäße Verfahren weiter. Dadurch lässt sich das erfindungsgemäße Verfahren zeit- und kostengünstiger durchführen.

Bevorzugt kann das erfindungsgemäße Verfahren ein Abschließen eines zweiten Endabschnitts des Ständerwicklungsstabs umfassen. Ein Abschließen des Ständerwicklungsstabs an dessen zweitem Ende hat den Vorteil, dass sich für die elektrisch nicht verbundenen Einzelleiter innerhalb des Ständerwicklungsstabs definierte Reflexionseigenschaften erreichen lassen. So kann das Abschließen einen Kurzschluss, einen gewünschten Widerstand oder den Wellenwiderstand des Ständerwicklungsstabs umfassen.

Es ist weiter bevorzugt, dass der Schritt des Abschließens ein Abschließen zumindest einer ersten Auswahl der Einzelleiter innerhalb des Ständerwicklungsstabs umfasst. Dadurch ergibt sich für die erste Auswahl der Einzelleiter ein definiertes Reflexionsverhalten, sofern die Isolierung zwischen den Einzelleitern der ersten Auswahl nicht beschädigt ist. Es ist weiter bevorzugt, dass der Schritt des Abschließens ein Abschließen der Vielzahl der Einzelleiter an dem zweiten Ende des Ständerwicklungsstabs umfasst, die durch das erfindungsgemäße Verfahren überprüft werden. Dies hat den Vorteil, dass die durch das Verfahren überprüfte Vielzahl von gegeneinander isolierten Einzelleitern in dem Ständerwicklungsstab ein definiertes Reflexionsverhalten zeigen, sofern die Isolierung zwischen diesen nicht beschädigt ist. Da die Anzahl der Einzelleiter innerhalb des Ständerwicklungsstabs bekannt ist, kann es weiter von Vorteil sein, sämtliche der Einzelleiter innerhalb des Ständerwicklungsstabs durch den gewünschten Widerstand, Kurzschluss oder Wellenwiderstand abzuschließen, um für sämtliche Einzelleiter innerhalb des Ständerwicklungsstabs definierte Reflexionseigenschaften zu erreichen, sofern die Einzelleiter galvanisch getrennt sind, das heißt sofern die Isolierung zwischen allen Einzelleitern des Ständerwicklungsstabs nicht beschädigt ist.

Bevorzugt umfasst der Schritt des Vergleichens ein Referenzsignal, das ein Überlagerungsreferenzsignal ist. Das Überlagerungsreferenzsignal wird mit einem Überlagerungssignal aus dem ersten Reflexionsanteil und dem Prüfsignal verglichen. Dieses Vorgehen hat den Vorteil, dass die Prüfung der Einzelleiter an einem Ende des Ständerwicklungsstabs möglich ist. Dadurch wird der für das Verfahren erforderliche Messaufbau vereinfacht.

Weiter bevorzugt kann das Verfahren ein Einkoppeln des Prüfsignals in eine zweite Auswahl der Einzelleiter des Ständerwicklungsstabs umfassen. Das Einkoppeln in die zweite Auswahl der Vielzahl der Einzelleiter kann an einem zweiten Abschnitt, insbesondere an einem zweiten Endabschnitt des Ständerwicklungsstabs erfolgen. Weiter kann das Verfahren ein Ermitteln eines zweiten Reflexionsanteils an dem zweiten Abschnitt oder dem zweiten Endabschnitt des Ständerwicklungsstabs umfassen. Das Vergleichen kann ein Vergleichen zumindest des zweiten Reflexionsanteils mit dem Referenzsignal und/oder dem ersten Reflexionsanteil umfassen. Durch dieses Vorgehen kann die Prüfung der Einzelleiter des Ständerwicklungsstabs sowohl an dessen erstem Ende als auch an dessen zweitem Ende erfolgen. Sofern die Reflexionsanteile an den beiden Abschnitten bzw. Endabschnitten voneinander abweichen, ist dies ein Hinweis auf eine Beschädigung der Isolierung zwischen den Einzelleitern innerhalb des Ständerwicklungsstabs und damit einer beeinträchtigten galvanischen Trennung dieser Einzelleiter.

Weiter bevorzugt umfasst das Prüfsignal einen zeitlichen Spannungsverlauf mit mindestens einer Flanke definierter Steilheit. Dabei ist definierte Steilheit dahingehend zu verstehen, dass in der Steilheit der Flanke ausreichend hohe Frequenzanteile enthalten sind, um eine mögliche Veränderung des Reflexionsanteils zuverlässig detektieren zu können, wie sie durch Beschädigung der Isolierung auftreten kann.

Weiter kann das Prüfsignal einen zeitlichen Spannungsverlauf mit mindestens einem Spannungsimpuls mit mindestens einer Flanke definierter Steilheit umfassen. Ebenso ist es möglich, dass der Spannungsimpuls zwei Flanken der definierten Steilheit umfasst. Weiter bevorzugt kann die definierte Steilheit einige Volt innerhalb weniger Nanosekunden oder Mikrosekunden betragen, vorzugsweise 0,1 bis 10 Volt pro Mikrosekunde oder höher betragen. Wobei die angegebenen Werte nur beispielhaft zu verstehen sind und keine Beschränkung der Erfindung darstellen.

Weiter bevorzugt kann das Prüfsignal einen zeitlichen Spannungsverlauf mit mindestens einem Maximum von einigen Volt, vorzugsweise 0,1 bis 80 Volt umfassen, diese Merkmale des zeitlichen Spannungsverlaufs haben den Vorteil, dass keine besonderen Sicherheitsvorkehrungen notwendig sind, wenn der Ständerwicklungsstab gemäß des erfindungsgemäßen Verfahrens überprüft wird. Wobei die angegebenen Werte nur beispielhaft zu verstehen sind und keine Beschränkung der Erfindung darstellen.

Die Erfindung schlägt weiter eine Vorrichtung zur Überprüfung einer Vielzahl von Einzelleitern in einem Ständerwicklungsstab einer elektrischen Maschine vor. Die Maschine umfasst eine Signalquelle und eine Messvorrichtung. Die Signalquelle ist eingerichtet zum Bereitstellen und Einkoppeln eines Prüfsignals in eine Vielzahl von Einzelleitern des Ständerwicklungsstabs. Die Messvorrichtung ist eingerichtet zum Ermitteln eines Reflexionsanteils und/oder eines Transmissionsanteils des Prüfsignals und zum Analysieren des Reflexionsanteils und/oder des Transmissionsanteils in Bezug auf ein Referenzsignal.

Weiter bevorzugt kann das Referenzsignal ein Überlagerungsreferenzsignal sein, und mit einen Überlagerungssignal aus dem ersten Reflexionsanteil und dem Prüfsignal ist. Dem Fachmann sind verschiedene Möglichkeiten, ein Überlagerungssignal zu erzeugen, bekannt, so kann das Überlagerungssignal zum Beispiel eine Addition aus dem Prüfsignal und des Reflexionssignals umfassen. Dadurch wird das resultierende Überlagerungssignal um den Reflexionsanteil reduziert. Ebenso ist es möglich, das Prüfsignal und den Reflexionsanteil gegeneinander aufzutragen, um sogenannte Lissajous-Figuren zu erzeugen. Dazu ist es bekanntermaßen vorteilhaft, dass das Prüfsignal entsprechende Wechselspannungsanteile enthält. Ebenso sind weitere Formen von Überlagerungssignalen und/oder Überlagerungsreferenzsignalen bekannt. Es ist vorteilhaft, das Überlagerungssignal aus Prüfsignal und Reflexionsanteil so zu wählen, dass sich im Falle einer Beschädigung der Isolation ein deutlicher Unterschied zu dem Überlagerungsreferenzsignal eines unbeschädigten Ständerwicklungsstabs, das heißt eines Ständerwicklungsstabs mit unbeschädigter Isolierung im Fehlerfall ergibt. Dabei ist der Fehlerfall zu verstehen als ein Ständerwicklungsstab, in dem zumindest eine Beschädigung der Isolierung zwischen den gegeneinander isolierten Einzelleitern besteht, so dass sich ein niederohmiger Schluss zwischen einzelnen der Einzelleiter ergibt.

Weiter bevorzugt handelt es sich bei der elektrischen Maschine um einen Generator. Dies ist vorteilhaft, da damit durch die erfindungsgemäße Vorrichtung Ständerwicklungsstäbe, wie sie in einem Generator zum Einsatz kommen, überprüft werden können. Ohne Einschränkung kann es sich bei der elektrischen Maschine auch um jede rotierende elektrische Maschine handeln, etwas einen Elektromotor oder den bereits erwähnten Generator. Daraus ergibt sich der Vorteil insbesondere große rotierende elektrische Maschinen schon bei deren Zusammenbau auf Korrektheit, das heißt die gewünschte elektrische Isolierung zwischen einzelnen der Einzelleiter hin zu überprüfen. Dadurch wird ein möglicher Leistungsverlust der elektrischen Maschine verhindert.

Im Folgenden werden bevorzugte Ausführungsformen des erfindungsgemäßen Verfahrens und der erfindungsgemäßen Vorrichtung anhand der beigefügten schematischen Zeichnung erläutert. Es zeigen:
- Figur 1a: eine erste Anordnung zur Durchführung des erfindungsgemäßen Verfahrens,
- Figur 1b: eine zweite Anordnung zur Durchführung des erfindungsgemäßen Verfahrens,
- Figur 2a: einen beispielhaften Verlauf von Referenzsignalen Uref und Reflexionsanteilen im Falle eines Überlagerungssignals U1+U2,
- Figur 2b: einen schematischen Signalverlauf des Referenzsignals Uref für den Reflexionsanteil im Falle einer unbeschädigten Isolierung und einer fehlerhaften Isolierung, und
- Figur 3: einen Ablaufplan des erfindungsgemäßen Verfahrens.

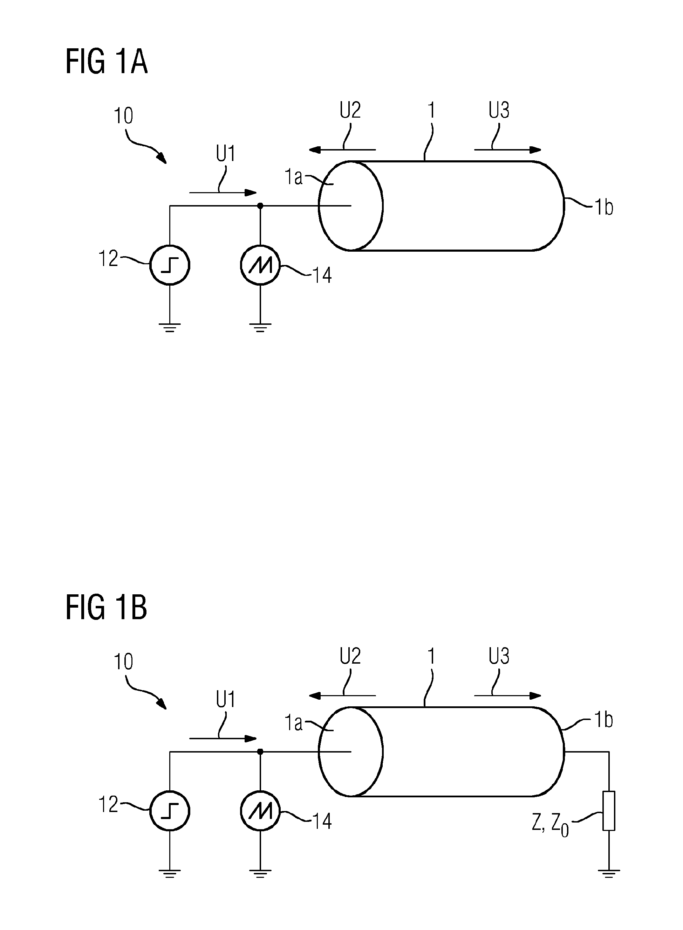

Figur 1 zeigt einen ersten Aufbau zur Durchführung des erfindungsgemäßen Verfahrens. Dazu wird ein Ständerwicklungsstab 1 an einem ersten Abschnitt, insbesondere an einem ersten Endabschnitt 1a mit einem Prüfsignal U1 beaufschlagt, wobei an einem zweiten Abschnitt des Ständerwicklungsstabs 1, insbesondere an dessen zweitem Endabschnitt 1b kein Abschluss oder Kurzschluss vorgesehen ist. Das Prüfsignal U1 kann von einer Signalquelle 12 bereitgestellt werden. Das Prüfsignal U1 propagiert entlang des Ständerwicklungsstabs 1. Es ist von Vorteil, das Prüfsignal U1 in eine Vielzahl der Einzelleiter innerhalb des Ständerwicklungsstabs 1 einzukoppeln, um mehrere der Einzelleiter mit der einen Messung prüfen zu können. Ohne Einschränkung ist es möglich, das Prüfsignal U1 in sämtliche der Einzelleiter des Ständerwicklungsstabs 1 einzukoppeln.

Dem Fachmann sind geeignete Mittel zum Einkoppeln 100 des Prüfsignals als erstem Verfahrensschritt bekannt. So kann das Einkoppeln 100 zum Beispiel eine elektrische Verbindung, ein kapazitives Einkoppeln und/oder ein induktives Einkoppeln des Prüfsignals U1 bedeuten. In Figur 1a ist als Abschnitt zum Einkoppeln 100 der erste Endabschnitt 1a des Ständerwicklungsstabs 1 gezeigt. Der Fachmann wird jedoch verstehen, dass ohne Einschränkung auch an jedem anderen Abschnitt des Ständerwicklungsstabs 1 das Einkoppeln 100 des Prüfsignals U1 in die Vielzahl der Einzelleiter erfolgen kann. Der Ort des Einkoppelns kann daher gemäß der herstellungsspezifischen Gegebenheiten gewählt werden. Das Prüfsignal U1 wird aufgrund des Wellenwiderstands des Ständerwicklungsstabs 1 entlang des Ständerwicklungsstabs 1 propagieren, wobei ein Transmissionsanteil U3 das zweite Ende 1b des Ständerwicklungsstabs 1 erreicht, während aufgrund des gegebenen Wellenwiderstands ein Reflexionsanteil U2 an dem Einkoppelabschnitt 1a - in der Figur als erster Endabschnitt des Ständerwicklungsstabs 1 gezeigt - reflektiert wird.

Sind nun aufgrund von Beschädigungen einer Isolation der Einzelleiter des Ständerwicklungsstabs 1 gegeneinander niederohmige Verbindungen oder Schlüsse zwischen einzelnen der Einzelleiter des Ständerwicklungsstabs 1 vorhanden, so ändert sich an diesen Fehlstellen der Wellenwiderstand des Ständerwicklungsstabs 1. Mit der Änderung des Wellenwiderstands des Ständerwicklungsstabs 1 geht auch eine Änderung des Reflexionsanteils U2 und des Transmissionsanteils U3 einher. Bei dem Einkoppeln 100 des Referenzsignals U1 in den ersten Endabschnitt 1a bzw. den ersten Abschnitt des Ständerwicklungsstabs 1 kann der dort gemessene Reflexionsanteil U2 auch als ein erster Reflexionsanteil bezeichnet werden. Der erste Reflexionsanteil U2 wird in einem Schritt des Ermittelns 200 bestimmt bzw. gemessen. Die deutliche Änderung dieses ersten Reflexionsanteils U2 im Fall einer niederohmigen Verbindung zwischen einzelnen der Einzelleiter lässt sich in einem Vergleichsschritt 300 des Verfahrens bestimmen. Dazu wird der erste Reflexionsanteil U2 mit einem Referenzsignal Uref für den fehlerfreien Fall verglichen, um eine Beschädigung der Isolierung zwischen einzelnen der Einzelleiter zu ermitteln. Dazu kann zum Beispiel eine Messvorrichtung 14 verwendet werden, etwa in Form eines Oszilloskops.

Der Fachmann wird verstehen, dass aufgrund der deutlichen Änderung des Wellenwiderstands im Fehlerfall auch eine deutliche Änderung eines Transmissionsanteils U3 des Prüfsignals U1 zur Detektion von Beschädigungen der Isolierung, das heißt niederohmigen Verbindungen zwischen einzelnen der Einzelleiter verwendet werden kann. Zur Messung des Transmissionsanteils U3 könnte die Messvorrichtung 14 auch an dem zweiten Endabschnitt 1b des Ständerwicklungsstabs 1 angebracht sein (nicht gezeigt).

Figur 1b zeigt einen alternativen Aufbau zur Durchführung des erfindungsgemäßen Verfahrens. Im Unterschied zu Figur 1a ist der zweite Endabschnitt 1b des Ständerwicklungsstabs 1 durch einen Widerstand Z, Z0 abgeschlossen. Die Verwendung des Widerstands hat den Vorteil, dass sich im Falle einer unbeschädigten Isolierung zwischen den Einzelleitern ein definiertes Reflexionsverhalten des Prüfsignals U1 entlang der Einzelleiter einstellen lässt. Durch den Widerstand Z, Z0 lässt sich etwa ein Kurschluss auf Masse oder ein Abschluss durch einen Wellenwiderstand Z0 der gegeneinander korrekt isolierten Einzelleiter erreichen.

Für den in Figuren 1a und 1b gezeigten Aufbau zur Durchführung des erfindungsgemäßen Verfahrens wird das Prüfsignal U1 nur an einem ersten Ende 1a des Ständerwicklungsstabs 1 eingekoppelt. Selbstverständlich ist es ohne Einschränkung möglich zusätzlich oder alternativ das Prüfsignal U1 an dem zweiten Endabschnitt 1b des Ständerwicklungsstabs 1 einzukoppeln. An dem zweiten Endabschnitt 1b wird das Prüfsignal U1 in zumindest eine zweite Auswahl der Einzelleiter des Ständerwicklungsstabs 1 eingekoppelt.

Es ist von Vorteil, dass das Einkoppeln 100a des Prüfsignals U1 in dieselben Einzelleiter erfolgt, die schon für das Einkoppeln 100 an dem ersten Abschnitt bzw. Endabschnitt 1a verwendet wurden. Weichen für diese beiden Messungen die jeweiligen Reflexionsanteile U2, U2' ab, so dass der erste Reflexionsanteil U2 an dem ersten Abschnitt bzw. Endabschnitt 1a verschieden ist von einem zweiten Reflexionsanteil U2 an dem zweiten Abschnitt bzw. Endabschnitt 1b des Ständerwicklungsstabs 1, so ist dies ein Hinweis auf Beschädigung der Einzelleiter. Das heißt, in einem Schritt des Vergleichens 300a des zweiten Reflexionsanteils U2' mit einem Referenzsignal Uref und/oder dem ersten Reflexionsanteil U2 ergibt sich ein deutlicher Unterschied, der auf die Beschädigung der Isolation der Einzelleiter gegeneinander hinweist.

Für den in Figur 1a und Figur 1b gezeigten Messaufbau ist ein Prüfsignal U1 von wenigen Volt mit einer definierten Flankensteilheit ausreichend. Die Flankensteilheit sollte im Bereich weniger Volt innerhalb weniger Mikrosekunden liegen. Ebenso ist es ohne weitere Einschränkung möglich, dass die Steilheit im Bereich weniger Volt pro Nanosekunden liegt. Da sich mit zunehmender Steilheit bekanntermaßen die Empfindlichkeit zur Detektion von Störstellen erhöht; denn mit zunehmender Steilheit ist ein größeres Frequenzspektrum in der Flanke enthalten ist.

Der Fachmann wird verstehen, dass im Falle einer Ermittlung des ersten Reflexionsanteils U2 an dem ersten Endabschnitt 1a und des zweiten Reflexionsanteils U2' (nicht gezeigt) an dem zweiten Endabschnitt 1b des Ständerwicklungsstabs 1 möglicherweise ein zur Länge des Ständerwicklungsstabs 1 symmetrisches Auftreten von Beschädigungen der Isolation bei dem Schritt des Vergleichens 300a übersehen werden kann.

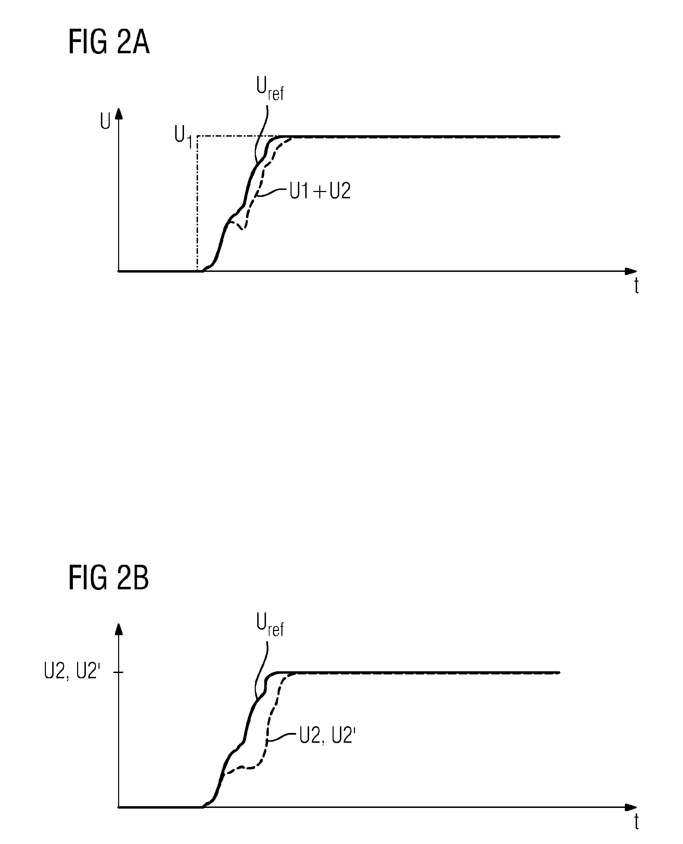

Figur 2a zeigt beispielhaft einen Verlauf eines Überlagerungssignals U1+U2 über der Zeit t. Im Falle einer nicht beschädigten Isolierung der Einzelleiter gegeneinander ergibt sich ein charakteristisches Signal Uref wie gezeigt. Aufgrund der deutlichen Änderung des Reflexionsanteils U2 im Falle einer beschädigten Isolierung zwischen einzelnen der Einzelleiter, ergibt sich eine deutliche Änderung des Reflexionsanteils U2 gleichermaßen an dem ersten Endabschnitt 1a oder dem zweiten Endabschnitt 1b des Ständerwicklungsstabs 1.

Es ist vorteilhaft, ein Überlagerungssignal U1+U2 über der Zeit aufzutragen, da im Fehlerfall das Überlagerungssignal U1+U2 abnimmt, so dass sich eine deutliche Abweichung zwischen dem Referenzsignal Uref und dem Überlagerungssignal U1+U2 ergibt. Dem Fachmann sind weitere Möglichkeiten von Überlagerungssignalen bekannt. Ohne Einschränkung könnte zum Beispiel der in Schritt 200 ermittelte Reflexionsanteil U2, U2' vergrößert oder verstärkt werden, um die Abweichung noch deutlicher zu machen. Es ist daher möglich, geeignete Darstellungen zu wählen, so dass sich in dem Schritt des Vergleichens 300a ein deutlicher Unterschied zwischen dem fehlerfreien Ständerwicklungsstab und einem fehlerhaften Ständerwicklungsstab ergibt.

Figur 2b zeigt beispielhaft einen Verlauf des ersten bzw. zweiten Reflexionssignals U2, U2' über der Zeit. Aufgrund der deutlichen Änderung des Wellenwiderstands im Falle einer beschädigten Isolierung, ergibt sich ein deutlicher Unterschied (wie gezeigt) zwischen dem Referenzsignal Uref und dem ersten bzw. dem zweiten Reflexionsanteil U2, U2'. Dieser deutliche Unterschied kann zur Ermittlung einer Beschädigung der Isolierung zwischen einzelnen der Einzelleiter herangezogen werden im Schritt des Vergleichens 300, 300a eines gewünschten Referenzsignals mit den jeweiligen Reflexionsanteilen U2, U2'.

Ohne Einschränkung könnte in dem Schritt des Ermittelns 200 anstelle des ersten Reflexionsanteils U2 bzw. des zweiten Reflexionsanteils U2' auch der am jeweils gegenüberliegenden Abschnitt bzw. Endabschnitt des Ständerwicklungsstabs 1 der nicht zum Einkoppeln verwendet wird, gemessene Transmissionsanteil U3, zur Ermittlung einer Beschädigung der Isolierung der Einzelleiter des Ständerwicklungsstabs gegeneinander verwendet werden. Die deutliche Änderung des Wellenwiderstands im Falle einer niederohmigen Verbindung einzelner der Einzelleiter wird sich auch auf den Transmissionsanteil U3 auswirken.

Dem Fachmann sind weitere Möglichkeiten bekannt, um ein Überlagerungssignal aus Prüfsignal U1, dessen Reflexionsanteil U2, U2', und/oder dem Transmissionsanteil U3 zu erzeugen, um einen deutlichen Unterschied bei dem Schritt des Ermittelns 300, 300a zwischen einer unbeschädigten Isolierung und einer beschädigten Isolierung zu erreichen. Denkbar sind zum Beispiel Darstellungen ausgewählter Signale aus dem Prüfsigna U1, dem Reflexionsanteil U2, U2' und/oder dem Transmissionsanteil U3 gegeneinander in Form von Lissajous-Figuren. Die in Figur 2a und 2b dargestellten Signalverläufe sind nur beispielhaft zu verstehen und keinesfalls als das Verfahren der Erfindung oder die Vorrichtung 10 einschränkend.
Dem Fachmann sind darüber hinaus Verfahren bekannt, um aus zu erwartenden Signalverläufen für den Fehlerfall und den fehlerfreien Fall Masken zu erstellen, so dass gegebenenfalls automatisch zwischen beiden Fällen unterschieden werden kann.

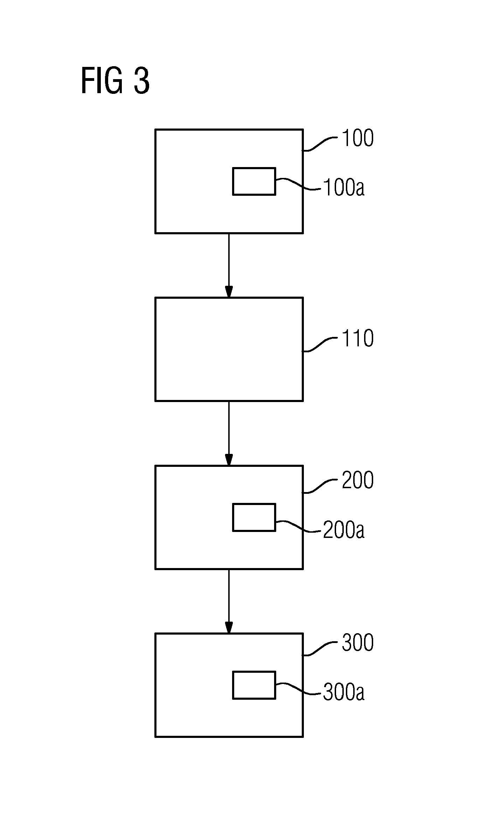

Figur 3 zeigt einen Ablaufplan des erfindungsgemäßen Verfahrens zur Überprüfung einer Vielzahl von gegeneinander isolierten Einzelleitern des Ständerwicklungsstabs 1. In einem Schritt 100 des Einkoppelns wird ein Prüfsignal U1 in die Vielzahl von Einzelleiter des Ständerwicklungsstabs 1 eingekoppelt. Dabei kann die Vielzahl von Einzelleitern sämtliche der in dem Ständerwicklungsstab 1 vorhandenen Einzelleiter umfassen, ebenso ist es ohne Einschränkung möglich, dass ein Einkoppeln in Schritt 100 nur in ausgewählte der gegeneinander isolierten Einzelleiter des Ständerwicklungsstabs 1 erfolgt. Der Schritt 100 kann alternativ oder zusätzlich einen Schritt des Einkoppelns 100a des Prüfsignals in zumindest eine zweite Auswahl der Vielzahl der Einzelleiter des Ständerwicklungsstabs an einem zweiten Abschnitt oder an einem zweiten Endabschnitt 1b des Ständerwicklungsstabs 1 umfassen.

Weiter kann das Verfahren vorteilhaft einen Schritt 110 des Abschließens eines zweiten Endabschnitts des Ständerwicklungsstabs 1 umfassen. Das Abschließen kann durch Kurzschluss, einen Widerstand Z oder den Wellenwiderstand Z0 des Ständerwicklungsstabs 1 erfolgen. Typischerweise erfolgt das Abschließen 110 an dem Endabschnitt des Ständerwicklungsstabs 1, der nicht zum Einkoppeln 100 des Prüfsignals verwendet wird. Wie beschrieben ändert sich durch den Schritt des Abschließens das Reflexionsverhalten für die korrekt gegeneinander isolierten Einzelleiter. Es kann von Vorteil sein alle Einzelleiter, in welche das Prüfsignal in dem Schritt 100 eingekoppelt wird, in Schritt 110 auch abzuschließen.

Das Verfahren umfasst gemäß Figur 3 weiter einen Schritt des Ermittelns 200 eines Anteils des Prüfsignals U1. Bei dem Ermitteln 200 kann es sich um das Ermitteln 200 des ersten Reflexionsanteils U2 und/oder des Transmissionsanteils U3 des Prüfsignals U1 handeln. Ebenso ist es optional möglich, dass in einem Schritt 200a der zweite Reflexionsanteil U2' des Prüfsignals U1 ermittelt wird.

In einem Schritt 300 wird zumindest der erste Reflexionsanteil U2 und/oder der Transmissionsanteil U3 mit einem Referenzsignal Uref verglichen, um eine Beschädigung einer Isolierung zwischen einzelnen der Vielzahl der Einzelleiter zu ermitteln. Optional kann der Schritt des Vergleichens 300 auch ein Vergleichen 300a zumindest des zweiten Reflexionsanteils U2' mit dem Referenzsignal Uref und/oder dem ersten Reflexionsanteil U2 umfassen. Die Schritte 300, 300a des Verfahrens können den im Zusammenhang mit Figuren 2a und 2b beschriebenen Möglichkeiten des Vergleichens umfassen.

Die erfindungsgemäße Vorrichtung 10 zur Überprüfung einer Vielzahl von Einzelleitern in einem Ständerwicklungsstab 1 einer elektrischen Maschine ist in Figuren 1a und 1b gezeigt. Die Vorrichtung 10 umfasst eine Spannungsquelle 12 zum Bereitstellen und Einkoppeln eines Prüfsignals U1 in die Vielzahl von Einzelleiter eines Ständerwicklungsstabs 1. Die Vorrichtung 10 umfasst weiter eine Messvorrichtung 14. Bei der Messvorrichtung 14 kann es sich zum Beispiel um ein Oszilloskop handeln. Die Messvorrichtung 14 dient zum Ermitteln eines Reflexionsanteils U2, eines zweiten Reflexionsanteils U2' und/oder eines Transmissionsanteils U3 des Prüfsignals U1. Weiter kann die Messvorrichtung 14 eine Analyse der Reflexionsanteile U2 und/oder U2' in Bezug auf ein Referenzsignal Uref ermöglichen. Dabei kennzeichnet das Referenzsignal Uref typischerweise ein entsprechendes Signal für einen Ständerwicklungsstab 1, dessen Isolierung zwischen den einzelnen Einzelleitern unbeschädigt ist. Die Vorrichtung 10 kann weiter Mittel zum Einkoppeln des Prüfsignals U1 in die Vielzahl der Einzelleiter umfassen. Die entsprechenden Mittel sind dem Fachmann bekannt und in Figur 1a und 1b nicht gezeigt. Ohne Einschränkung kann die Spannungsquelle 12 und die Messvorrichtung 14 auch als eine Vorrichtung 10 ausgeführt sein. Optional kann die Vorrichtung 10 weiter einen Widerstand Z, Z0 zum Abschließen des Ständerwicklungsstabs umfassen. Bei dem Referenzsignal Uref kann es sich ohne Einschränkung um die oben in Zusammenhang mit Figur 2a und 2b beschriebenen Formen des Referenzsignals handeln.

Obwohl die Erfindung im Detail durch bevorzugte Ausführungsformen beschrieben und näher illustriert wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Überprüfung einer Vielzahl von gegeneinander isolierten Einzelleitern in einem Ständerwicklungsstab (1) einer elektrischen Maschine, das Verfahren umfassend:
- Einkoppeln (100) eines Prüfsignals (U1) in die Vielzahl von Einzelleitern des Ständerwicklungsstabs (1),
- Ermitteln (200) eines ersten Anteils des Prüfsignals (U1),
- Vergleichen (300) zumindest des ersten Anteils des Prüfsignals (U1) mit einem Referenzsignal (Uref), um eine Beschädigung einer Isolierung zwischen einzelnen der Vielzahl der Einzelleiter zu ermitteln.

2. Verfahren gemäß Anspruch 1,
wobei der Schritt des Ermittelns (200) ein Ermitteln eines ersten Reflektionsanteils (U2) des Prüfsignals (U1) und/oder eines ersten Transmissionsanteils (U3) umfasst.

3. Verfahren gemäß Anspruch 2,
wobei der Schritt des Einkoppelns (100) ein Einkoppeln an einem ersten Abschnitt des Ständerwicklungsstabs (1) oder an einem ersten Endabschnitt (1a) des Ständerwicklungsstabs (1) umfasst, und wobei der Schritt des Ermittelns (200) ein Ermitteln des ersten Reflexionsanteils (U2) an dem ersten Abschnitt oder an dem ersten Endabschnitt (1a) umfasst.

4. Verfahren gemäß einem der vorhergehenden Ansprüche, weiter umfassend:
- Abschließen (110) eines zweiten Endabschnitts (1b) des Ständerwicklungsstabs (1) durch einen Kurzschluss, einen Widerstand (Z) oder den Wellenwiderstand (Z0) des Ständerwicklungsstabs (1).

5. Verfahren nach Anspruch 4,
wobei der Schritt des Abschließens (110) ein Abschließen zumindest einer ersten Auswahl der Vielzahl von Einzelleitern, vorzugsweise der Vielzahl der Einzelleiter an dem zweiten Ende (1b) des Ständerwicklungsstabs umfasst.

6. Verfahren nach einem der Ansprüche 2 bis 5,
wobei für den Schritt des Vergleichens (300) das Referenzsignal (Uref) ein Überlagerungsreferenzsignal ist, das mit einem Überlagerungssignal (U1+U2) aus dem ersten Reflexionsanteil (U2) und dem Prüfsignal (U1) verglichen wird.

7. Verfahren nach einem der vorhergehenden Ansprüche, weiter umfassend:
- Einkoppeln (100a) des Prüfsignals (U1) in zumindest eine zweite Auswahl der Vielzahl der Einzelleiter des Ständerwicklungsstabs (1) an einem zweiten Abschnitt des Ständerwicklungsstabs (1) oder an einem zweiten Endabschnitt (1a) des Ständerwicklungsstabs (1),
- Ermitteln (200a) eines zweiten Reflexionsanteils an dem zweiten Abschnitt oder dem zweiten Endabschnitt (1b), und
- Vergleichen (300a) zumindest des zweiten Reflexionsanteils (U2') mit dem Referenzsignal und/oder dem ersten Reflexionsanteil (U2).

8. Verfahren nach einem der vorhergehenden Ansprüche, wobei das Prüfsignal (U1) einen zeitlichen Spannungsverlauf mit mindestens einer Flanke einer definierten Steilheit umfasst.

9. Verfahren nach einem der vorhergehenden Ansprüche, wobei das Prüfsignal (U1) einen zeitlichen Spannungsverlauf mit mindestens einem Spannungsimpuls mit mindestens einer Flanke definierter Steilheit umfasst.

10. Verfahren nach einem der Ansprüche 7 oder 8,
wobei die definierte Steilheit einige Volt innerhalb weniger Nanosekunden beträgt, vorzugsweise 0,1 bis 10 Volt pro Nanosekunde oder höher.

11. Verfahren nach einem der vorhergehenden Ansprüche,
wobei das Prüfsignal (U1) mindestens ein zeitlicher Spannungsverlauf mit mindestens einem Maximum von einigen Volt ist, vorzugsweise im Bereich von 0,1 bis 80 Volt.

12. Vorrichtung (10) zur Überprüfung einer Vielzahl von Einzelleitern in einem Ständerwicklungsstab (1) einer elektrischen Maschine, die Vorrichtung (10) umfassend:
- eine Signalquelle (12) eingerichtet zum Bereitstellen und Einkoppeln eines Prüfsignals (U1) in die Vielzahl von Einzelleitern,
- eine Messvorrichtung (14) eingerichtet zum Ermitteln eines Reflexionsanteils (U2, U2') und/oder eines Transmissionsanteils (U3) des Prüfsignals (U1) und zum Analysieren des Reflexionsanteils (U2, U2') und/oder des Transmissionsanteils (U3) in Bezug auf ein Referenzsignal (Uref).

13. Vorrichtung (10) gemäß Anspruch 11,
wobei das Referenzsignal (Uref) eine Überlagerungsreferenzsignal ist, und mit einem Überlagerungssignal (U1+U2) aus dem ersten Reflexionsanteil (U2) und dem Prüfsignal (U1) ist.

14. Vorrichtung (10) gemäß einem der Ansprüche 11 oder 12,
wobei die elektrische Maschine ein Generator ist.

15. Vorrichtung (10) gemäß einem der Ansprüche 11 bis 13,
wobei das Referenzsignal (Uref) eine Überlagerungsreferenzsignal ist, und mit einem Überlagerungssignal (U1+U2') aus dem zweiten Reflexionsanteil (U2') und dem Prüfsignal (U1) ist.
